# EUROPÄISCHE PATENTSCHRIFT

(11) **EP 3 194 636 B1**
(45) Veröffentlichungstag und Bekanntmachung des Hinweises auf die Patenterteilung: **13.05.2020**
(21) Anmeldenummer: 15770460.2
(22) Anmeldetag: 08.09.2015
(51) Int. Cl.: C23C 16/26, C23C 16/34, C23C 16/04, B22C 3/00, B22C 9/12, B22C 9/06, B22D 11/059, B22D 15/00

(54) **GUSSFORM UND VERFAHREN ZUR HERSTELLUNG**
CASTING MOULD AND METHOD FOR PRODUCING SAME
MOULE ET PROCÉDÉ DE FABRICATION

(30) Priorität: 15.09.2014 DE 102014218449
(43) Veröffentlichungstag der Anmeldung: 26.07.2017
(73) Patentinhaber: Schunk Kohlenstofftechnik GmbH, 35452 Heuchelheim (DE)
(72) Erfinder: GALLE, Johannes, 56414 Hundsangen (DE); MARKOVIC, Milisav, 35444 Biebertal (DE)
(74) Vertreter: advotec.
(86) Internationale Anmeldenummer: PCT/EP2015/070435
(87) Internationale Veröffentlichungsnummer: WO 2016/041809

(56) Entgegenhaltungen:
- WO-A2-02/095080
- AT-B- 322 128
- GB-A- 2 171 039

## Beschreibung

Die Erfindung betrifft ein Verfahren zur Herstellung einer Gussform für Metallguss sowie eine Gussform, insbesondere eine Stranggusskokille oder dergleichen, wobei die Gussform aus einem überwiegend aus Kohlenstoff bestehenden Material ausgebildet wird, wobei die Gussform mit pyrolytischem Kohlenstoff und/oder Bornitrid beschichtet wird.

Derartige Gussformen sind hinreichend bekannt und werden regelmäßig zur Herstellung von Halbzeugen, wie Stangen mit unterschiedlichen Querschnittprofilen verwendet. Eine Herstellung derartiger Halbzeuge erfolgt derart, dass in einem Tiegel Metall aufgeschmolzen oder geschmolzenes Metall in den Tiegel eingefüllt wird, wobei an dem Tiegel eine Öffnung mit einer Stranggusskokille ausgebildet ist. Aus der Stranggusskokille wird das in der Kokille plastifizierte Metall kontinuierlich heraus gezogen. Eine Stranggusskokille kann insbesondere bei der Herstellung von Halbzeugen aus Nichteisenmetallen mit kleineren Querschnitten vollständig aus einem überwiegend aus Kohlenstoff bestehenden Material oder vollständig aus Kohlenstoff bzw. aus Graphit ausgebildet sein, wobei eine geometrische Form einer von der Stranggusskokille ausgebildeten Öffnung einem Querschnitt eines hergestellten Halbzeugs entspricht.

Die Stranggusskokille selbst wird aus einem Graphitblock durch spanende Bearbeitung, beispielsweise Drehen oder Fräsen, ausgebildet. Nachteilig bei den bekannten Stranggusskokillen ist, dass diese vergleichsweise schnell verschleißen und regelmäßig ausgewechselt werden müssen. Das Auswechseln einer Stranggusskokille ist besonders aufwendig, da ein kontinuierlicher Gießprozess zur Demontage der Stranggusskokille über einen längeren Zeitraum unterbrochen werden muss. Ein Verschleiß ergibt sich unter anderem dadurch, dass es zu einer Korrosion der aus Graphit ausgebildeten Stranggusskokille durch die Metallschmelze kommt. Weiter kann das flüssige Metall bzw. Legierungsbestandteile des flüssigen Metalls in den Graphit der Stranggusskokille bzw. durch die Graphitkokille hindurch diffundieren. Auch in der Metallschmelze enthaltene Gase oder Gase aus dem Prozess bzw. einer Umgebung können zu einer schnellen Korrosion der Graphitkokille beitragen. Dies hat unter anderem zur Folge, dass sich eine Oberflächenqualität und Maßhaltigkeit des erzeugten Halbzeugs im Laufe eines Lebenszyklus einer Stranggusskokille verschlechtert. Ist eine Qualität eines erzeugten Halbzeugs nicht mehr akzeptabel, ist es erforderlich, die Stranggusskokille auszutauschen. Ähnlich geartete Probleme können auch bei aus Graphit ausgebildeten Dauerformen auftreten.

Die AT 322 128 B offenbart ein Verfahren zur Herstellung einer Gussform bzw. einer Stranggusskokille, die aus Graphit besteht, wobei der Graphitkörper der Stranggusskokille mit pyrolytischem Kohlenstoff oder Bornitrid beschichtet ist. Die pyrolytische Beschichtung erfolgt im Rahmen eines CVD-Prozesses bei einer Temperatur von 1700 bis 2300 °C. Insbesondere wird auf die Vorteile der pyrolytischen Beschichtung, wie die Wärmeleitfähigkeit und die nahezu porenfreie Oberfläche, verwiesen. Bornitrid wird als eine Alternative zu pyrolytischem Kohlenstoff angegeben.

Die GB 2 171 039 A betrifft eine Graphitgussform, die mittels eines CVD-Verfahrens bei einer Temperatur von 900 bis 950 °C beschichtet wird. Die Gussform kann insbesondere aus Graphit bestehen, und die Dicke der Beschichtung kann von 20 bis 80 µm variieren.

Die WO 02/095080 A2 offenbart eine Gussform aus Graphit, beschichtet mit einer pyrolytischen Graphitschicht mit einer Dicke von 0,1 bis 5 mm. Auch hier wird zur Beschichtung ein CVD-Verfahren mit einer Temperatur von 1700 bis 2200 °C verwandt. Weiter ist ein nachfolgendes Glühen bei 2600 °C vorgesehen. Eine Porosität der Graphitschicht beträgt weniger als 1 %.

Der vorliegenden Erfindung liegt die daher die Aufgabe zugrunde, ein Verfahren zur Herstellung einer Gussform, eine Gussform sowie eine Verwendung einer derartigen Gussform vorzuschlagen, mit dem bzw. der ein Gießprozess kostengünstiger durchgeführt werden kann.

Diese Aufgabe wird durch ein Verfahren mit den Merkmalen des Anspruchs 1, eine Gussform mit den Merkmalen des Anspruchs 8 und eine Verwendung einer Gussform mit den Merkmalen des Anspruchs 16 gelöst.

Bei dem erfindungsgemäßen Verfahren zur Herstellung einer Gussform für Metallguss, insbesondere einer Stranggusskokille oder dergleichen, wird die Gussform aus einem überwiegend aus Kohlenstoff bestehenden Material ausgebildet, wobei die Gussform mit pyrolytischem Kohlenstoff und/oder Bornitrid beschichtet wird, wobei eine Beschichtung der Gussform bei einer Temperatur von 500 °C bis 1900 °C aufgebracht wird, wobei während einer Prozessdauer einer Beschichtung der Gussform die Beschichtung innerhalb eines ersten Prozessabschnitts mit einem CVI-Verfahren bei einer ersten Temperatur, und nachfolgend innerhalb eines zweiten Prozessabschnitts mit einem CVD-Verfahren bei einer zweiten Temperatur aufgebracht wird, wobei der erste Prozessabschnitt länger als der zweite Prozessabschnitt gewählt ist und die erste Temperatur niedriger als die zweite Temperatur gewählt ist.

Die erfindungsgemäße Gussform wird zunächst vollständig aus dem aus überwiegend aus Kohlenstoff bestehenden Material ausgebildet, derart, dass die Gussform ein aus dem Material bestehender Körper ist. Der Körper weist dabei eine poröse Struktur, bedingt durch das Herstellungsverfahren und eine homogene Orientierung des Kristallgefüges des Materials, auf. So ist auch eine Oberfläche des Körpers porös, wodurch die Oberfläche insgesamt vergrößert ist. Durch die poröse Struktur können daher die Metallschmelze bzw. deren Bestandteile in das Material der Gussform diffundieren, wobei diese auch aufgrund ihrer vergrößerten Oberfläche leicht korrodieren kann. Dadurch dass mit dem erfindungsgemäßen Verfahren die Gussform mit pyrolytischem Kohlenstoff und/oder Bornitrid beschichtet wird, können vorhandene Poren des Körpers der Gussform durch Ausbildung einer ergänzenden Schicht bzw. Beschichtung geschlossen bzw. verschlossen werden. Auch ist der Körper der Gussform aus dem Material einfach in einem Beschichtungsverfahren mit pyrolytischem Kohlenstoff oder Bornitrid zu beschichten, wobei diese Materialien eine hohe mechanische und chemische Beständigkeit aufweisen. Durch das Beschichten wird eine dem flüssigen Metall oder Gasen ausgesetzte Oberfläche des Körpers wesentlich verkleinert, wodurch die Gussform korrosionsbeständiger wird. Insbesondere pyrolytischer Kohlenstoff weist, im Vergleich zu beispielsweise Graphit, einen anderen Kristallisationsgrad sowie eine niedrigere Oxidationsrate und Ätzrate auf, woraus sich alleine eine Verbesserung der Korrosionsbeständigkeit ergibt. Auch wird mit derart ausgebildeten Beschichtungen eine Diffusionssperre gegenüber der Schmelze bzw. deren Bestandteilen ausgebildet. Hieraus ergibt sich eine wesentlich längere Standzeit der Gussform, wodurch beispielsweise bei einer Verwendung der Gussform als Stranggusskokille längere Wechselintervalle realisiert werden können, was folglich zu geringeren Kosten eines Produktionsprozesses und von Metallgussprodukten führt. Auch wird der Produktionsprozess insgesamt dadurch kostengünstiger, dass mit einer Gussform mehr Metallgussprodukte hergestellt werden können.

Das erfindungsgemäße Verfahren kann zur Herstellung einer Stranggusskokille eingesetzt werden.

Das Verfahren ist jedoch nicht alleine auf Stranggusskokillen beschränkt, da alle aus einem Graphitkörper bestehenden oder aus Einzelteilen aus überwiegend aus Kohlenstoff bestehenden Material ausgebildeten Gussformen mit dem erfindungsgemäßen Verfahren hergestellt werden können. Auch kann die Gussform vollständig aus Kohlenstoff und vorzugsweise aus Graphit ausgebildet werden.

In einer Ausführungsform des Verfahrens kann vorgesehen sein, dass die Gussform mit einer Oberflächenschicht aus pyrolytischen Kohlenstoff beschichtet wird. Demnach kann die Oberfläche des Körpers der Gussform mit einer ergänzenden, auf die Oberfläche aufgebrachte Oberflächenschicht versehen werden, die die Poren des Graphits des Körpers überdeckt und verschließt. Auch ist es besonders vorteilhaft, dass die Beschichtung dann aus pyrolytischen Kohlenstoff bzw. aus pyrolytischen Graphit besteht, da es sich dann im Wesentlichen um das gleiche Material handeln kann, wie das Material des Körpers der Gussform.

Weiter kann die Gussform auch mit pyrolytischen Kohlenstoff infiltriert werden, wobei dann der pyrolytische Kohlenstoff bzw. der pyrolytische Graphit zunächst in die Poren des Körpers der Gussform eindringt und diese im Wesentlichen vollständig ausfüllt. Der pyrolytische Kohlenstoff dringt dann nur bis zu einer bestimmten Tiefe in den Körper der Gussform ein, so dass eine Infiltrationsschicht der Schicht bzw. Beschichtung ausgebildet wird. Die Beschichtung kann so noch inniger mit dem Körper der Gussform verbunden werden. Alleine eine Infiltration kann somit schon eine Schicht im Körper bzw. eine Beschichtung des Körpers der Gussform ausbilden.

Erfindungsgemäß erfolgt ein Beschichten der Gussform mittels eines CVD-Verfahrens (Chemische Gasphasenabscheidung) und eines CVI-Verfahrens (Chemische Gasphaseninfiltration) . Insbesondere wenn der Graphit der Gussform porös ist, kann dann der Körper der Gussform nicht nur oberflächlich beschichtet werden, sondern auch besonders einfach infiltriert werden. Dabei ist vorgesehen, zunächst das CVI-Verfahren und nachfolgend das CVD-Verfahren anzuwenden.

So können bei einem Beschichten der Gussform bzw. des Körpers der Gussform Poren im Graphit der Gussform mit dem pyrolytischen Kohlenstoff ausgefüllt werden. Bereits durch das Ausfüllen der Poren kann eine Diffusionssperre ausgebildet und eine Korrosionsbeständigkeit erhöht werden.

Erfindungsgemäß wird bei dem Verfahren eine Beschichtung der Gussform bzw. des Körpers der Gussform bei einer Temperatur von 500 °C bis 1900 °C aufgebracht . Somit ist es möglich, die Beschichtung der Gussform auch bei vergleichsweise niedrigen Temperaturen aufzubringen, wodurch das Verfahren einfacher und kostengünstiger ausführbar wird.

Vorzugsweise kann bei dem Verfahren eine Beschichtung der Gussform bzw. des Körpers der Gussform bei einer Temperatur von 600 °C bis unter 1700 °C aufgebracht werden.

Auch ist erfindungsgemäß vorgesehen , während einer Prozessdauer einer Beschichtung der Gussform bzw. des Körpers der Gussform die Beschichtung innerhalb eines ersten Prozessabschnitts bei einer ersten Temperatur, und nachfolgend innerhalb eines zweiten Prozessabschnitts bei einer zweiten Temperatur aufzubringen, wobei der erste Prozessabschnitt länger als der zweite Prozessabschnitt gewählt ist und die erste Temperatur niedriger als die zweite Temperatur gewählt ist . So ist es dann beispielsweise möglich, zunächst eine Infiltration des Körpers der Gussform mit beispielsweise pyrolytischem Kohlenstoff durchzuführen, wobei die Infiltration dann über einen vergleichsweise langen Prozesszeitraum bei niedriger Prozesstemperatur vorteilhaft erfolgen kann. Eine äußere Beschichtung einer Oberfläche des Körpers der Gussform kann nachfolgend durch eine Erhöhung der Prozesstemperatur auf das zweite Temperaturniveau aufgebracht werden. Der dann ausgeführte, zweite Prozessabschnitt bei der erhöhten Prozesstemperatur kann dann vergleichsweise kürzer verlaufen. Beispielsweise könnte so auch eine Beschichtung mit pyrolytischem Kohlenstoff innerhalb eines ununterbrochenen Beschichtungsprozesses einfach erfolgen.

Darüber hinaus kann eine thermische Nachbehandlung, wie beispielsweise Nachglühen, Nachgraphittieren usw., nach einem Aufbringen der Beschichtung unterbleiben. Ein weiterer Behandlungsschritt der Gussform, der auch über eine gewählte Prozesstemperatur hinausgehen kann, ist dann nicht mehr erforderlich.

Die erfindungsgemäße Gussform für Metallguss, insbesondere eine Stranggusskokille oder dergleichen, ist aus einem überwiegend aus Kohlenstoff bestehenden Material ausgebildet, wobei die Gussform mit pyrolytischen Kohlenstoff und/oder Bornitrid beschichtet ist, wobei eine Beschichtung der Gussform bei einer Temperatur von 500 °C bis 1900 °C aufgebracht ist, wobei während einer Prozessdauer einer Beschichtung der Gussform die Beschichtung innerhalb eines ersten Prozessabschnitts mit einem CVI-Verfahren bei einer ersten Temperatur, und nachfolgend innerhalb eines zweiten Prozessabschnitts mit einem CVD-Verfahren bei einer zweiten Temperatur aufgebracht ist, wobei der erste Prozessabschnitt länger als der zweite Prozessabschnitt gewählt ist und die erste Temperatur niedriger als die zweite Temperatur gewählt ist. Hinsichtlich der Vorteile einer derart ausgebildeten Gussform wird auf die Vorteilsbeschreibung des erfindungsgemäßen Verfahrens verwiesen.

Die Gussform kann einstückig oder mehrteilig ausgebildet sein. D.h. ein beispielsweise aus Kohlenstoff bzw. Graphit ausgebildeter Körper der Gussform kann einstückig ausgebildet sein, wobei die Gussform auch aus mehreren aus Graphit ausgebildeten Körpern ausgebildet sein kann, die zu einer Gussform zusammengesetzt werden können. Wesentlich ist, dass es sich bei der Gussform bzw. dem Körper der Gussform nicht alleine um eine Beschichtung eines Formkörpers aus Metall oder anderen Werkstoffen handelt, sondern um einen dreidimensionalen, geometrischen Gegenstand bzw. Formkörper.

Die Gussform kann so ausgebildet sein, dass eine Oberfläche der Gussform vollständig beschichtet ist. Alternativ können alleine Oberflächenbereiche der Gussform beschichtet sein, die mit flüssigem Metall in Kontakt gelangen können. Oberflächenbereiche der Gussform, die nicht mit flüssigem Metall in Kontakt gelangen, müssen dann nicht zwangsläufig beschichtet sein. Ein Verfahren zur Beschichtung der Gussform kann dadurch gegebenenfalls vereinfacht werden.

Eine Oberflächenschicht der Beschichtung der Gussform kann mit einer Schichtdicke von 5 µm bis 500 µm, bevorzugt von 5 µm bis 100 µm, und besonders bevorzugt von 5 µm bis 50 µm ausgebildet sein. Eine Oberflächenschicht betrifft dann eine auf einer Oberfläche eines Körpers der Gussform aufgebrachte Schicht bzw. Beschichtung, wobei bereits schon mit einer Oberflächenschicht von 5 µm ein merklicher Effekt hinsichtlich einer Ausbildung einer Diffusionssperre und einer verbesserten Korrosionsbeständigkeit erzielt werden kann. Es ist somit nicht erforderlich, bei der betreffenden Gussform dickere Oberflächenschichten aufzubringen.

Vorteilhaft kann eine Oberflächenschicht der Beschichtung der Gussform bzw. des Körpers der Gussform aus anisotropen Kohlenstoff ausgebildet sein. So kann beispielsweise die für die Beschichtung erforderliche Festigkeit optimiert und gleichzeitig die betreffende Schicht vergleichsweise dünn ausgebildet sein. Auch kann durch den anisotropen Kohlenstoff eine Korrosionsbeständigkeit der Oberflächenschicht verbessert werden.

Weiter kann eine Infiltrationsschicht der Beschichtung der Gussform bzw. des Körpers der Gussform mit einer Schichtdicke von zumindest 1 µm bis 100 µm, bevorzugt von bis zu 500 µm, und besonders bevorzugt von bis zu 2500 µm ausgebildet sein. Die Infiltrationsschicht betrifft dann eine Schicht bzw. Beschichtung, die unterhalb der Oberfläche des Körpers der Gussform und innerhalb des Körpers ausgebildet ist. Auch hier ist es bereits möglich, mit einer vergleichsweise dünnen Infiltrationsschicht eine Diffusionssperre auszubilden sowie eine merklich verbesserte Korrosionsbeständigkeit des Körpers der Gussform zu erzielen. Grundsätzlich ist es jedoch vorteilhaft eine möglichst tief in den Körper hinein reichende Infiltrationsschicht zu erhalten.

Darüber hinaus kann vorgesehen sein, eine Infiltrationsschicht feinkristalliner auszubilden als eine Oberflächenschicht der Beschichtung der Gussform. Durch die feinkristalline Ausbildung ergibt sich eine besonders gute chemische Resistenz.

Die Beschichtung kann eine Porosität von kleiner 1 %, bevorzugt kleiner 0,1 %, und besonders bevorzugt von 0 % aufweisen. Mit einer Porosität von im Wesentlichen 0 % kann die Beschichtung besonders gasdicht sein, also eine sehr wirkungsvolle Diffusionssperre ausbilden.

Vorteilhaft kann die Beschichtung als eine Korrosionsschutzschicht ausgebildet sein. Eine Standzeit der Gussform, insbesondere wenn die Gussform eine Stranggusskokille ist, wird dadurch wesentlich erhöht.

Weitere vorteilhafte Ausführungsformen einer Gussform ergeben sich aus den Merkmalsbeschreibungen der auf den Verfahrensanspruch 1 rückbezogenen Unteransprüche.

Erfindungsgemäß wird die Gussform nach einem der Ansprüche 11 bis 19 zur Herstellung eines aus Metall bestehenden Gusserzeugnisses verwendet, wobei das Gusserzeugnis mit der Gussform hergestellt wird. Das Gusserzeugnis kann dabei insbesondere ein Halbzeug, vorzugsweise aus einem Nichteisenmetall, sein.

Nachfolgend wird eine bevorzugte Ausführungsform der Erfindung unter Bezugnahme auf die beigefügten Zeichnungen näher erläutert.

Es zeigen:
- **Fig. 1**: eine Längsschnittansicht einer Stranggusskokille;
- **Fig. 2**: eine Detailansicht einer Beschichtung;
- **Fig. 3**: eine Diagrammdarstellung eines Beschichtungsprozesses.

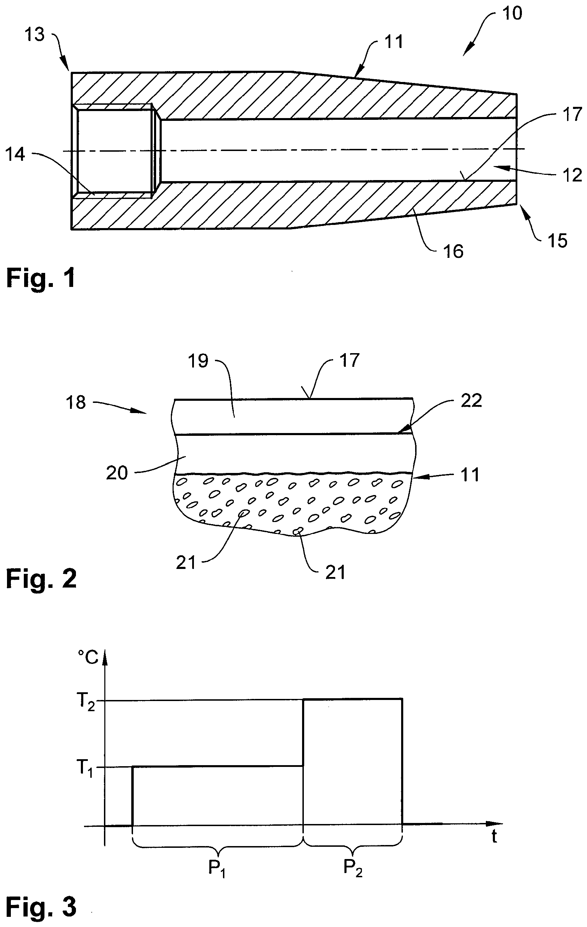

Die **Fig. 1** zeigt eine Stranggusskokille 10, wie sie regelmäßig zur Herstellung von Halbzeugen aus Nichteisenmetallen im Stranggussverfahren verwendet wird. Die Stranggusskokille 10 ist einstückig aus einem Körper 11, welcher aus Graphit besteht, ausgebildet. Der Körper 11 ist dabei rotationssymmetrisch ausgebildet und weist eine Durchgangsöffnung 12 auf. An einem Tiegelende 13 des Körpers 11 ist in der Durchgangsöffnung 12 ein Innengewinde 14 ausgebildet, mittels dem die Stranggusskokille 10 an einem hier nicht näher dargestellten Tiegel fest montiert werden kann. Ein Ziehende 15 des Körpers 11 ist frei, d. h. nicht verbindbar ausgebildet. Der Körpers 11 weist hier eine sich kegelstumpfförmig verjüngende Wandung 16 auf. Eine Oberfläche 17 der Stranggusskokille 10 ist insbesondere mit pyrolytischen Kohlenstoff beschichtet.

Zur Herstellung eines hier nicht dargestellten Rundstabes aus Nichteisenmetall, wie beispielsweise aus Messing oder Bronze, strömt nun flüssiges Metall am Tiegelende 13 in die Durchgangsöffnung 12 ein und erstarrt innerhalb des Körpers 11 der Stranggusskokille, so dass an dem Ziehende 15 das dann plastifizierte Metall aus der Stranggusskokille 10 herausgezogen werden kann.

Die **Fig. 2** zeigt eine Vergrößerung einer Beschichtung 18 der Stranggusskokille 10 bzw. des Körpers 11 im Bereich der Oberfläche 17. Die Beschichtung 18 umfasst eine Oberflächenschicht 19 und eine Infiltrationsschicht 20. Der Körper 11 weist eine Vielzahl von Poren 21 auf, die unbeschichtet eine Diffusion von geschmolzenem Metall oder Schmelzebestandteilen in den Körper 11 ermöglichen würden. Innerhalb der Infiltrationsschicht 20 ist der Körper 11 bzw. sind die dort befindlichen und hier dann nicht mehr sichtbaren Poren mit pyrolytischen Kohlenstoff infolge eines angewandten Beschichtungsverfahrens infiltriert und im Wesentlichen vollständig ausgefüllt. Die Oberflächenschicht 19 ist auf den Körper 11 bzw. auf eine vor einem Beschichten von dem Körper 11 ausgebildete Oberfläche 22 aufgebracht. Die Oberflächenschicht 19 ist dabei anisotrop ausgebildet und weist eine Porosität von im Wesentlichen 0 % auf. Die Infiltrationsschicht 20 ist gegenüber der Oberflächenschicht 19 feinkristalliner ausgebildet.

Die **Fig. 3** zeigt ein Diagramm eines Prozesses zur Beschichtung der Stranggusskokille 10. Während einer Prozessdauer t des Beschichtungsprozesses der Stranggusskokille 10 bzw. des Körpers 11 beträgt innerhalb eines ersten Prozessabschnitts P1 die Temperatur T1 beispielsweise 600 °C, wobei nach dem ersten Prozessabschnitt P1 eine zweiter Prozessabschnitt P2 erfolgt, bei dem eine zweite Temperatur T2 von beispielsweise 1700 °C angewendet wird. Während des ersten Prozessabschnittes P1 wird die Infiltrationsschicht 20 ausgebildet, wobei während des zweiten Prozessabschnittes P2 die Oberflächenschicht 19 ausgebildet wird. Als ein Beschichtungsverfahren ist ein CVI-Verfahren bzw. ein CVD-Verfahren vorgesehen.

## Patentansprüche

1. Verfahren zur Herstellung einer Gussform (10) für Metallguss, insbesondere einer Stranggusskokille , wobei die Gussform aus einem überwiegend aus Kohlenstoff bestehenden Material ausgebildet wird, wobei
die Gussform mit pyrolytischem Kohlenstoff und/oder Bornitrid beschichtet wird,
**dadurch gekennzeichnet,**
**dass** eine Beschichtung (18) der Gussform bei einer Temperatur von 500 °C bis 1900 °C aufgebracht wird, wobei während einer Prozessdauer einer Beschichtung der Gussform die Beschichtung innerhalb eines ersten Prozessabschnitts (P1) mit einem CVI-Verfahren bei einer ersten Temperatur (T1), und nachfolgend innerhalb eines zweiten Prozessabschnitts (P2) mit einem CVD-Verfahren bei einer zweiten Temperatur (T2) aufgebracht wird, wobei der erste Prozessabschnitt länger als der zweite Prozessabschnitt gewählt ist und die erste Temperatur niedriger als die zweite Temperatur gewählt ist.

2. Verfahren nach Anspruch 1,
**dadurch gekennzeichnet,**
**dass** die Gussform (10) aus Kohlenstoff ausgebildet wird.

3. Verfahren nach Anspruch 2,
**dadurch gekennzeichnet,**
**dass** die Gussform (10) aus Graphit ausgebildet wird.

4. Verfahren nach einem der vorangehenden Ansprüche,
**dadurch gekennzeichnet,**
**dass** die Gussform (10) mit einer Oberflächenschicht (19) aus pyrolytischem Kohlenstoff beschichtet wird.

5. Verfahren nach einem der vorangehenden Ansprüche,
**dadurch gekennzeichnet,**
**dass** die Gussform (10) mit pyrolytischen Kohlenstoff infiltriert wird.

6. Verfahren nach einem der vorangehenden Ansprüche,
**dadurch gekennzeichnet,**
**dass** bei einem Beschichten der Gussform (10) Poren (21) im Graphit der Gussform (10) mit dem pyrolytischen Kohlenstoff geschlossen oder ausgefüllt werden.

7. Verfahren nach einem der vorangehenden Ansprüche,
**dadurch gekennzeichnet,**
**dass** eine thermische Nachbehandlung nach einem Aufbringen der Beschichtung (18) unterbleibt.

8. Gussform für Metallguss, insbesondere eine Stranggusskokille , wobei die Gussform aus einem überwiegend aus Kohlenstoff bestehenden Material ausgebildet ist, wobei
die Gussform (10) mit pyrolytischem Kohlenstoff und/oder Bornitrid beschichtet ist,
**dadurch gekennzeichnet,**
**dass** eine Beschichtung (18) der Gussform bei einer Temperatur von 500 °C bis 1900 °C aufgebracht ist, wobei während einer Prozessdauer einer Beschichtung der Gussform die Beschichtung innerhalb eines ersten Prozessabschnitts (P1) mit einem CVI-Verfahren bei einer ersten Temperatur (T1), und nachfolgend innerhalb eines zweiten Prozessabschnitts (P2) mit einem CVD-Verfahren bei einer zweiten Temperatur (T2) aufgebracht ist, wobei der erste Prozessabschnitt länger als der zweite Prozessabschnitt gewählt ist und die erste Temperatur niedriger als die zweite Temperatur gewählt ist.

9. Gussform nach Anspruch 8 ,
**dadurch gekennzeichnet,**
**dass** die Gussform (10) einstückig oder mehrteilig ausgebildet ist.

10. Gussform nach Anspruch 8 oder 9 ,
**dadurch gekennzeichnet,**
**dass** eine Oberfläche (17) der Gussform (10) vollständig beschichtet ist.

11. Gussform nach einem der Ansprüche 8 bis 10 ,
**dadurch gekennzeichnet,**
**dass** eine Oberflächenschicht (19) der Beschichtung (18) der Gussform (10) in einer Schichtdicke von 5 µm bis 500 µm, bevorzugt von 5 µm bis 100 µm, und besonders bevorzugt von 5 µm bis 50 µm ausgebildet ist.

12. Gussform nach einem der Ansprüche 8 bis 11 ,
**dadurch gekennzeichnet,**
**dass** eine Oberflächenschicht (19) der Beschichtung (18) der Gussform (10) aus anisotropem Kohlenstoff ausgebildet ist.

13. Gussform nach einem der Ansprüche 8 bis 12 ,
**dadurch gekennzeichnet,**
**dass** eine Infiltrationsschicht (20) der Beschichtung (18) der Gussform (10) in einer Schichtdicke von zumindest 1 µm bis 100 µm, bevorzugt von bis zu 500 µm, und besonders bevorzugt von bis zu 2500 µm ausgebildet ist.

14. Gussform nach einem der Ansprüche 8 bis 13 ,
**dadurch gekennzeichnet,**
**dass** die Beschichtung (18) eine Porosität von kleiner 1 %, bevorzugt kleiner 0,1 %, und besonders bevorzugt von 0 % aufweist.

15. Gussform nach einem der Ansprüche 8 bis 14 ,
**dadurch gekennzeichnet,**
**dass** die Beschichtung (18) als Korrosionsschutzschicht ausgebildet ist.

16. Verwendung einer Gussform (10) nach einem der Ansprüche 8 bis 15 zur Herstellung eines aus Metall bestehenden Gusserzeugnisses, insbesondere Halbzeug, wobei das Gusserzeugnis mit der Gussform hergestellt wird.

## Claims

1. A method for producing a casting mold (10) for metal casting, in particular a continuous casting mold, said casting mold being made of a material made predominantly of carbon, the casting mold being coated with pyrolytic carbon and/or boron nitride,
**characterized in that**
a coating (18) of the casting mold is applied at a temperature of 500 °C to 1900 °C, wherein, during a process time of coating the casting mold, the coating is applied during a first process phase (P1) at a first temperature (T1) by means of a CVI method and subsequently applied during a second process phase (P2) at a second temperature (T2) by means of a CVD method, the first process phase being chosen so as to be longer than the second process phase and the first temperature being chosen so as to be lower than the second temperature.

2. The method according to claim 1,
**characterized in that**
the casting mold (10) is made of carbon.

3. The method according to claim 2,
**characterized in that**
the casting mold (10) is made of graphite.

4. The method according to any one of the preceding claims,
**characterized in that**
the casting mold (10) is coated with a surface coating (19) made of pyrolytic carbon.

5. The method according to any one of the preceding claims,
**characterized in that**
the casting mold (10) is infiltrated with pyrolytic carbon.

6. The method according to any one of the preceding claims,
**characterized in that**
pores (21) in the graphite of the casting mold (10) are sealed or filled with pyrolytic carbon when coating the casting mold (10).

7. The method according to any one of the preceding claims,
**characterized in that**
thermal post-processing is omitted after applying the coating (18).

8. A casting mold for metal casting, in particular a continuous casting mold, said casting mold being made of a material predominantly made of carbon,
the casting mold (10) being coated with pyrolytic carbon and/or boron nitride
**characterized in that**
a coating (18) of the casting mold is applied at a temperature of 500 °C to 1900 °C, wherein, during a process time of coating the casting mold, the coating is applied during a first process phase (P1) at a first temperature (T1) by means of a CVI method and subsequently applied during a second process phase (P2) at a second temperature (T2) by means of a CVD method, the first process phase being chosen so as to be longer than the second process phase and the first temperature being chosen so as to be lower than the second temperature.

9. The casting mold according to claim 8,
**characterized in that**
the casting mold (10) is made in one piece or in several pieces.

10. The casting mold according to claim 8 or 9,
**characterized in that**
a surface (17) of the casting mold (10) is entirely coated.

11. The casting mold according to any one of the claims 8 to 10,
**characterized in that**
a surface coating (19) of the coating (18) of the casting mold (10) is made having a coating thickness of 5 µm to 500 µm, preferably 5 µm to 100 µm, and particularly preferably 5 µm to 50 µm.

12. The casting mold according to any one of the claims 8 to 11,
**characterized in that**
a surface coating (19) of the coating (18) of the casting mold (10) is made of anisotropic carbon.

13. The casting mold according to any one of the claims 8 to 12,
**characterized in that**
an infiltration coating (20) of the coating (18) of the casting mold (10) is made having a coating thickness of at least 1 µm to 100 µm, preferably up to 500 µm, and particularly preferably up to 2500 µm.

14. The casting mold according to any one of the claims 8 to 13,
**characterized in that**
the coating (18) has a porosity of less than 1 %, preferably less than 0.1 %, and particularly preferably 0 %.

15. The casting mold according to any one of the claims 8 to 14,
**characterized in that**
the coating (18) is made as an anti-corrosion layer.

16. A usage of a casting mold (10) according to any one of the claims 8 to 15 for producing a casting product made of metal, in particular semi-finished products, said casting product being produced using the casting mold.

## Revendications

1. Procédé pour la production d'un moule (10) de coulage pour la coulée des métaux, en particulier un moule de coulage continu, le moule de coulage étant fait d'un matériau consistant en majorité en carbone, le moule de coulage étant revêtu de carbone pyrolytique et/ou de nitrure de bore,
**caractérisé en ce qu'**
un revêtement (18) du moule de coulage est appliqué à une température de 500 °C à 1900 °C, dans lequel, pendant un temps de procédé de revêtir le moule de coulage, le revêtement est appliqué pendant une première phase (P1) de procédé à une première température (T1) au moyen d'un méthode de CVI et subséquemment est appliqué pendant une deuxième phase (P2) de procédé à une deuxième température (T2) au moyen d'un méthode de CVD, la première phase de procédé étant choisie de telle façon qu'elle est plus longue que la deuxième phase de procédé et la première température étant choisie de telle façon qu'elle est plus basse que la deuxième température.

2. Procédé selon la revendication 1,
**caractérisé en ce que**
le moule (10) de coulage est fait de carbone.

3. Procédé selon la revendication 2,
**caractérisé en ce que**
le moule (10) de coulage est fait de graphite.

4. Procédé selon l'une quelconque des revendications précédentes,
**caractérisé en ce que**
le moule (10) de coulage est revêtu d'une couche (19) de surface fait de carbone pyrolytique.

5. Procédé selon l'une quelconque des revendications précédentes,
**caractérisé en ce que**
le moule (10) de coulage est infiltré avec du carbone pyrolytique.

6. Procédé selon l'une quelconque des revendications précédentes,
**caractérisé en ce que**
des pores (21) dans le graphite du moule (10) de coulage sont scellés ou remplis avec du carbone pyrolytique lorsque le moule (10) de coulage est revêtu.

7. Procédé selon l'une quelconque des revendications précédentes,
**caractérisé en ce qu'**
un traitement ultérieur thermique n'est pas effectué après que le revêtement (18) est appliqué.

8. Moule de coulage pour la coulée des métaux, en particulier un moule de coulage continu, le moule de coulage étant fait d'un matériau consistant en majorité en carbone, le moule (10) de coulage étant revêtu de carbone pyrolytique et/ou de nitrure de bore,
**caractérisé en ce qu'**
un revêtement (18) du moule de coulage est appliqué à une température de 500 °C à 1900 °C, dans lequel, pendant un temps de procédé de revêtir le moule de coulage, le revêtement est appliqué pendant une première phase (P1) de procédé à une première température (T1) au moyen d'un méthode de CVI et subséquemment est appliqué pendant une deuxième phase (P2) de procédé à une deuxième température (T2) au moyen d'un méthode de CVD, la première phase de procédé étant choisie de telle façon qu'elle est plus longue que la deuxième phase de procédé et la première température étant choisie de telle façon qu'elle est plus basse que la deuxième température.

9. Moule de coulage selon la revendication 8,
**caractérisé en ce que**
le moule (10) de coulage est fait d'une pièce ou de plusieurs pièces.

10. Moule de coulage selon la revendication 8 ou 9,
**caractérisé en ce qu'**
une surface (17) du moule (10) de coulage est complètement revêtue.

11. Moule de coulage selon l'une quelconque des revendications 8 à 10,
**caractérisé en ce qu'**
une couche (19) de surface du revêtement (18) du moule (10) de coulage a une épaisseur de couche de 5 µm à 500 µm, de préférence de 5 µm à 100 µm, et de préférence particulière de 5 µm à 50 µm.

12. Moule de coulage selon l'une quelconque des revendications 8 à 11,
**caractérisé en ce qu'**
une couche(19) de surface du revêtement (18) du moule (10) de coulage est fait de carbone anisotrope.

13. Moule de coulage selon l'une quelconque des revendications 8 à 12,
**caractérisé en ce qu'**
une couche(20) d'infiltration du revêtement (18) du moule (10) de coulage a un épaisseur de couche d'au moins 1 µm à 100 µm, de préférence allant jusqu'à 500 µm, et de préférence particulière allant jusqu'à 2500 µm.

14. Moule de coulage selon l'une quelconque des revendications 8 à 13,
**caractérisé en ce que**
le revêtement (18) a une porosité inférieure à 1 %, de préférence inférieure à 0,1 %, et de préférence particulière de 0 %.

15. Moule de coulage selon l'une quelconque des revendications 8 à 14,
**caractérisé en ce que**
le revêtement (18) est fait comme couche anticorrosion.

16. Usage d'un moule (10) de coulage selon l'une quelconque des revendications 8 à 15 pour la production d'un produit coulé fait de métal, en particulier des produits semi-finis, le produit coulé étant produit en utilisant le moule de coulage.
